# EUROPÄISCHE PATENTSCHRIFT

(11) **EP 3 048 868 B1**
(45) Veröffentlichungstag und Bekanntmachung des Hinweises auf die Patenterteilung: **22.11.2017**
(21) Anmeldenummer: 16151748.7
(22) Anmeldetag: 18.01.2016
(51) Int. Cl.: H01R 9/26, H01R 12/72, H01R 24/64, H05K 7/14

(54) **KOMMUNIKATIONSEINHEIT**
COMMUNICATION UNIT
UNITÉ DE COMMUNICATION

(30) Priorität: 23.01.2015 DE 102015201187
(43) Veröffentlichungstag der Anmeldung: 27.07.2016
(73) Patentinhaber: Power Plus Communications AG, 68167 Mannheim (DE)
(72) Erfinder: Veselcic, Marko, 67122 Altrip (DE)
(74) Vertreter: Patent- und Rechtsanwälte Ullrich & Naumann

(56) Entgegenhaltungen:
- EP-A2- 1 137 334
- EP-A2- 1 160 952
- WO-A1-2012/003541
- JP-A- 2006 032 238
- US-A- 6 050 853

## Beschreibung

Die Erfindung betrifft eine Kommunikationseinheit mit einem Gehäuse zur Montage auf einer Tragschiene und mit mindestens einer in dem Gehäuse angeordneten Platine, wobei das Gehäuse eine der Tragschiene zugewandte Seite - Montageseite - und eine Frontseite aufweist, wobei auf einer der mindestens einen Platine - erste Platine - eine Einbaubuchse angeordnet ist, wobei die Einbaubuchse eine Einstecköffnung aufweist, in die durch eine Öffnung in der Frontseite ein korrespondierender Stecker einsteckbar ist, und wobei durch die Einstecköffnung eine Achse definiert ist, entlang der ein eingesteckter Stecker angeordnet ist

Kommunikationssysteme bestehen häufig aus mehreren separaten Einheiten, die kommunizierend miteinander verbunden sind. Als Beispiele für derartige Systeme sei auf Telefonanlagen, Hausautomatisierungssysteme, moderne Türsprechanlagen oder SmartMeter-Systeme (Systeme mit einem oder mehreren intelligenten Zählern meist für Strom, Gas oder Wasser) verwiesen. In vielen Fällen sind die einzelnen Einheiten des Kommunikationssystems mit Steckverbindern untereinander verbunden. Insbesondere bei IP (Internet Protocol)-basierter Kommunikation haben sich RJ (Registered Jack)-Steckverbinder etabliert, die von der US-amerikanischen FCC (Federal Communications Commission) genormt sind. Bei kupferkabel-gebundener Kommunikation über Ethernet ist insbesondere RJ45 weit verbreitet, bei dem bei Vollbeschaltung acht Kontaktpositionen mit acht Kontakten vorgesehen sind (8P8C-Modularstecker bzw. -buchse) und dessen Verkabelung nach EIA/TIA-568 standardisiert ist.

Zum Verbinden einer Kommunikationseinheit mit einer anderen ist in der Kommunikationseinheit jeweils eine Einbaubuchse vorgesehen, in die ein korrespondierender Stecker eingesteckt werden kann. Mit dem Stecker ist ein mehradriges Kommunikationskabel verbunden, an dessen anderen Ende üblicherweise ebenso ein Stecker zum Einstecken in eine andere Kommunikationseinheit angeordnet ist. Eine derartige Einbaubuchse weist einen Grundkörper auf, der verschiedentlich ausgebildet sein kann, an dem aber zumindest eine Anschlussseite und eine Einsteckseite ausgebildet sind. An der Anschlussseite sind Anschlussmittel angeordnet, die zum Verbinden der Einbaubuchse mit Leiterbahnen auf einer Platine ausgebildet sind, wobei die Anschlussmittel meist mit den Leiterbahnen verlötet werden. Mit Verbinden der Einbaubuchse mit einer Platine ist die Anschlussseite im Wesentlichen parallel zu dieser Platine. In der Einsteckseite ist eine Einstecköffnung ausgebildet, in die der korrespondierende Stecker einsteckbar ist. Durch die Ausgestaltung der Einstecköffnung ist eine Achse definiert, entlang der ein Stecker nach dem Einstecken in die Einstecköffnung angeordnet ist. Bei vielen Steckverbinder, beispielsweise bei RJ45, fällt die Einsteckrichtung, entlang der ein Stecker in die Einstecköffnung eingesteckt wird, im Wesentlichen mit der Achse der Einstecköffnung zusammen.

Kommunikationseinheiten können in den verschiedensten Gehäusen angeordnet sein. Neben weit verbreiteten Kommunikationseinheiten für 19"-Racks oder zur Montage an einer Wand sind auch Kommunikationseinheiten in Tragschienengehäusen gebräuchlich. Sehr häufig werden dabei Tragschienen in Form einer Hutschiene nach EN 50022 (auch bekannt als DIN Rail) verwendet, die in Elektroverteilern weite Verbreitung finden. In Deutschland sind die Abmessungen von zugehörigen Gehäusen sowie deren Einbaumaße nach DIN 43880 genormt. Danach ist die Oberfläche einer Berührungsschutzabdeckung im Abstand von 52 mm von der Oberkante der Hutschiene angeordnet, die die Kontakte der einzelnen Hutschienengehäuse gegen Berührung und Manipulation schützen. Das Hutschienengehäuse selbst darf die Berührungsschutzabdeckung maximal um 10 mm überragen, so dass das Hutschienengehäuse von der Oberkante der Hutschiene gemessen maximal 62 mm hoch sein darf. Im Abstand von 70 mm von der Hutschiene ist eine Türe oder eine andere Frontverkleidung angeordnet, die den gesamten Verteiler mit den einzelnen Hutschienengehäusen und der Berührungsschutzabdeckung abschließt. Innerhalb dieser Vorgaben muss sich ein normgerecht aufgebautes Hutschienengehäuse bewegen. Bei anderen Tragschienensystemen gelten ähnliche Vorgaben.

Die Seite des Gehäuses, die der Tragschiene zugewandt ist, wird nachfolgend auch als Montageseite bezeichnet. Zudem umfasst das Gehäuse eine Frontseite, die im montierten Zustand des Gehäuses sichtbar bleibt. Im Falle eines Hutschienengehäuses ist die Frontseite die Seite des Gehäuses, die vor der Berührungsschutzabdeckung, d.h. relativ zu der Hutschiene auf der gegenüberliegenden Seite der Berührungsschutzabdeckung, liegt und parallel zu der Berührungsschutzabdeckung bzw. parallel zu der Montageseite angeordnet ist.

In der Praxis sind verschiedenste Kommunikationseinheiten in Hutschienengehäusen bekannt. Beispiele hierfür sind IP-Gateways für Türsprechanlagen (beispielsweise von der Firma Gira), IP-Gateways oder andere Interfaces für einen KNX-Bus (beispielsweise von der Firma Weinzierl Engineering GmbH) oder SmartMeter-Gateways. Auf letztere wird nachfolgend beispielshaft genauer eingegangen.

In Deutschland sind gewisse Ausgestaltungen eines SmartMeter-Gateways nach dem Gesetz über die Elektrizitäts- und Gasversorgung (EnWG) und dort insbesondere die §§ 21e, 21f und 21i vorgeschrieben, die in einem Schutzprofil und einer Technischen Richtlinie des Bundesamts für Sicherheit in der Informationstechnik (BSI) weiter konkretisiert sind. Die Aufgabe eines SmartMeter-Gateways besteht darin, eine verschlüsselte Kommunikation zwischen einem SmartMeter und dem Versorgungsunternehmen (Energie, Wasser, etc.) sowie eine Beschränkung des Zugriffs auf bekannte Teilnehmer und Geräte sicherzustellen. Hierzu weist das SmartMeter-Gateway mehrere Schnittstellen auf, insbesondere eine Schnittstelle zu einem WAN (Wide Area Network), eine Schnittstelle zu einem LMN (Local Metrological Network) und eine Schnittstelle zu einem HAN (Home Area Network). Die HAN-Schnittstelle ist dabei für den Endkunden vorgesehen, um beispielsweise Verbrauchs- und/oder Einspeisewerte abzufragen. Gleichzeitig können über die HAN-Schnittstelle steuerbare Geräte angesteuert werden oder ein Techniker kann einen Systemstand abfragen. Daher ist die HAN-Schnittstelle im Gehäuse für einen Endkunden zugänglich angeordnet, d.h. ein zugehöriger Anschluss, meist eine RJ45-Buchse, liegt an der Frontseite des Gehäuses vor der Berührungsschutzabdeckung.

Aus der Praxis sind bei Kommunikationseinheiten in Hutschienengehäuse verschiedene Anordnungen einer RJ45-Einbaubuchse bekannt So ist beispielsweise bei dem bereits erwähnten KNX-IP-Gateway der Firma Weinzierl Engineering GmbH die Achse der Einstecköffnung senkrecht zu der Frontseite angeordnet. Nachteilig hieran ist, dass ein RJ45-Stecker weit über die Oberseite des Hutschienengehäuses hinausragt. Bei dem bereits angesprochenen Türsprechsystem-IP-Gateway der Firma Gira ist die Achse der Einstecköffnung der RJ45-Buchse parallel zu der Frontseite ausgebildet. Hierzu ist der Bereich zwischen Berührungsschutzabdeckung und Frontseite so breit ausgestaltet, dass eine RJ45-Buchse Platz findet bzw. ein RJ45-Stecker einsteckbar ist. Nachteilig hieran ist, dass das Hutschienengehäuse nicht die geforderten Einbaumaße einhalten kann, da das Gehäuse zwangsläufig um mehr als 10 mm über die Berührungsschutzabdeckung hinausragt. Bei SmartMeter-Gateways sind RJ45-Buchsen gebräuchlich, bei denen die Achse der Einstecköffnung einen Winkel von 45° ±3° zu der Frontseite einschließt. Nachteilig daran ist, dass keine Standard-RJ45-Kabel mit Knickschutzhüllen verwendet werden können. Meist kommen stattdessen Spezialkabel zum Einsatz, wie z.B. Slimline-Patchkabel der Marke Shiverpeaks. Alternativ werden Kabel eingesetzt, die keine Knickschutzhüllen aufweisen. Allerdings sind sowohl Spezialkabel als auch Kabel ohne Knickschutzhüllen weniger belastbar und daher anfällig gegen Beschädigung.

Der vorliegenden Erfindung liegt daher die Aufgabe zugrunde, eine Kommunikationseinheit der eingangs genannten Art derart auszugestalten und weiterzubilden, dass auf den Einsatz von Spezialkabeln beim Verbinden mit einer Einbaubuchse der Kommunikationseinheit verzichtet werden kann und dennoch geforderte Einbaumaße eingehalten werden können.

Erfindungsgemäß wird die voranstehende Aufgabe durch die Merkmale des Anspruchs 1 gelöst. Danach ist die in Rede stehende Kommunikationseinheit dadurch gekennzeichnet, dass die erste Platine senkrecht zur Montageseite angeordnet ist und dass die Einbaubuchse derart auf der ersten Platine angeordnet ist, dass die Achse der Einstecköffnung relativ zu der Montageseite einen Winkel zwischen 15° und 30° einschließt

In erfindungsgemäßer Weise ist zunächst erkannt worden, dass auf die Verwendung von Spezialkabeln oder anderen anfälligen Kabeln auf vergleichsweise einfache Art und Weise verzichtet werden kann. Als erste Maßnahme wird hierzu eine Platine, auf der die betreffende Einbaubuchse angeordnet ist, nachfolgend auch als erste Platine bezeichnet, derart angeordnet, dass sie senkrecht zur Montageseite angeordnet ist. Die Montageseite ist die Seite des Gehäuses, die einer Tragschiene zugewandt ist, wenn das Gehäuse auf der Tragschiene montiert ist. Im montierten Zustand der Kommunikationseinheit ist damit die erste Platine senkrecht zu der Ebene angeordnet, die durch die Tragschiene aufgespannt ist. Bei der Ausgestaltung der Tragschiene als Hutschiene ist die erste Platine vorzugsweise derart angeordnet, dass die Hutschiene senkrecht zu einer durch die Platine aufgespannten Ebene ist.

Erfindungsgemäß wird ferner eine Einbaubuchse derart auf die erste Platine angeordnet, dass die Achse der Einstecköffnung relativ zu der Montageseite einen Winkel zwischen 15° und 30° einschließt. Dies bedeutet, dass die Einbaubuchse derart auf der ersten Platine gedreht angeordnet ist, dass der erfindungsgemäß verwendete Winkelbereich eingehalten wird. Dadurch können übliche, auf dem Markt befindliche Einbaubuchsen verwendet werden, beispielsweise Einbaubuchsen, bei denen die Achse der Einstecköffnung parallel zu der Platine angeordnet ist. Hierzu müssen eventuell Bohrungen in der Platine oder entsprechende Leiterbahnen für beispielsweise eine SMD (Service Mounted Device)-Montage geeignet angeordnet sein. Dies stellt jedoch eine recht geringe Anforderung dar. Durch den erfindungsgemäß ausgewählten Winkelbereich können Vorgaben hinsichtlich der Einbaumaße einer Kommunikationseinheit auf der Tragschiene eingehalten werden, während gleichzeitig der Biegeradius des zu einem eingesteckten Stecker gehörenden Kabels eingehalten werden kann. Übliche Kabel, die für RJ45-Stecker verwendet werden, dürfen üblicherweise in einem minimalen Biegeradius von achtmal dem Durchmesser des Kabels gebogen werden. Durch die erfindungsgemäße Auswahl des Winkelbereichs zwischen 15° und 30° (Randwerte jeweils eingeschlossen) können sowohl der Biegeradius des Kabels als auch die maximal zulässigen Abmessungen eingehalten werden.

Der Erfinder hat festgestellt, dass bei einem Winkel von 15° ein RJ45-Stecker derart in eine Einbaubuchse in einem Hutschienengehäuse eingesteckt werden kann, dass der Stecker ausreichend oberhalb der Berührungsschutzabdeckung angeordnet ist. Bis zu einem Winkel von 30° ist der RJ45-Stecker so bezüglich des Hutschienengehäuses angeordnet, dass er wieder gut aus der Einbaubuchse entnommen werden kann. Damit können durch den erfindungsgemäßen Winkelbereich übliche Handhabungsanforderungen, wie einfaches Einstecken und einfaches Entnehmen der RJ45-Stecker, gewährleistet werden, wobei gleichzeitig die minimal zulässigen Biegeradien, die maximal zulässigen Ausmaße des Gehäuses und andere Randbedingungen eingehalten werden. Damit kann durch die Auswahl des erfindungsgemäßen Winkelbereichs auf die Verwendung von Spezialkabel oder Kabel ohne Knickschutzhülle verzichtet werden. Die Verwendung von Standardkabeln, insbesondere Standard-RJ45-Kabeln, ist möglich.

Als besonders vorteilhaft hat sich ein Winkelbereich zwischen 18° und 25° herausgestellt. In diesem Bereich sind die Randbedingungen derart gut erfüllt, dass die Dimensionierung als annähernd optimal angesehen werden kann. Als ganz besonders günstig hat sich ein Winkel von 19° erwiesen, so dass in einer ganz besonders bevorzugten Ausgestaltung ein Winkelbereich von +/- 1° um 19° gewählt ist. In diesem Bereich sind die Randbedingungen optimal eingehalten und es ist ein recht enger aber dennoch gut zu realisierender Toleranzbereich gegeben.

In einer Ausgestaltung der Einbaubuchse ist die durch die Einstecköffnung definierte Achse im Wesentlichen parallel zu der ersten Platine ausgerichtet. Diese Art von Einbaubuchsen ist, beispielsweise bei RJ45-Buchsen, sehr weit verbreitet und damit kostengünstig verfügbar. Dies wirkt sich begünstigend auf die Kosten der Kommunikationseinheit aus.

In einer anderen Ausgestaltung weist die Achse der Einstecköffnung relativ zu der ersten Platine in einem Winkel zwischen 9° und 50° auf. Eine derartige Ausgestaltung begünstigt das Verlegen des in die Einbaubuchse eingesteckten Kabels. Dadurch kann das Kabel quer über das Gehäuse oder von dem Gehäuse weg verlegt werden, um beispielsweise besser mit einem Kabel in einen Zwischenraum zu anderen Hutschienengehäusen gelangen zu können. Ferner kann dadurch der Biegeradius des Kabels weiter reduziert werden. Bevorzugte Beispiele einer derartigen Einbaubuchse sind 45° ±3°. Ein anderer bevorzugter Winkelbereich ist bei 19° ±3°, der in der deutschen Patentanmeldung 10 2015 201 118 der Anmelderin näher beschrieben ist.

Zum Einstecken eines Steckers in die Einbaubuchse ist in dem Gehäuse eine Öffnung ausgebildet, die zumindest teilweise in der Frontseite des Gehäuses angeordnet ist. Damit die Einbaubuchse zum Einstecken eines Steckers möglichst gut erreichbar ist, ist die Einbaubuchse vorzugsweise an einem Randbereich der ersten Platine angeordnet. Dabei steht die Einbaubuchse vorzugsweise derart über die erste Platine hinaus, dass bei einer Anordnung der ersten Platine im Gehäuse die Einbaubuchse mit ihrem am weitesten von der ersten Platine entfernt liegenden Punkt maximal wenige Millimeter unterhalb der Frontseite endet, vorzugsweise bündig mit der Frontseite abschließt. Bei einer Kommunikationseinheit in einem Hutschienengehäuse bedeutet dies, dass die Einbaubuchse bei dem von der Hutschiene abgewandten Rand angeordnet ist und mit einer Ecke über die erste Platine hinaussteht. Diese Ecke befindet sich in der zugehörigen Öffnung in dem Gehäuse und endet an der Oberfläche der betreffenden Wandung oder ist wenige Millimeter (beispielsweise 5 mm) unterhalb der Oberfläche angeordnet.

Prinzipiell können verschiedenste Steckverbinder durch die Einbaubuchse und den korrespondierenden Stecker Verwendung finden. Einem Fachmann wird die Eignung entsprechender Steckverbinder problemlos feststellen können. Wesentlich dabei ist, dass durch die Einbaubuchse eine Achse im Sinne der hier beschriebenen Lehre gebildet ist. In einer bevorzugten Ausbildung ist die Einbaubuchse jedoch als RJ (Registered Jack)-Buchse, ganz besonders bevorzugter Weise als RJ45-Buchse ausgebildet.

Auf der ersten Platine oder gegebenenfalls auf einer anderen in dem Gehäuse angeordneten Platine, kann eine weitere Einbaubuchse angeordnet sein. Die Kommunikationseinheit kann dabei derart ausgebildet sein, dass ein über die Einbaubuchse verbundenes Endgerät mit einem anderen über die weitere Einbaubuchse verbundenen Endgerät kommunizieren kann. Diese Funktion ist insbesondere dann relevant, wenn die Kommunikationseinheit ein Gateway ist. Dabei kann die weitere Einbaubuchse im Fall eines Hutschienengehäuses vor der Berührungsschutzabdeckung oder auch hinter der Berührungsschutzabdeckung angeordnet sein. Eine Anordnung der weiteren Einbaubuchse hinter der Berührungsschutzabdeckung, d.h. im Bereich zwischen Berührungsschutzabdeckung und Hutschiene, ist insbesondere dann sinnvoll, wenn an die weitere Einbaubuchse ein Gerät angeschlossen werden soll, das von einem Endnutzer nicht getrennt oder nicht durch ein anderes Gerät ausgetauscht werden darf.

In einer bevorzugten Ausgestaltung ist die Kommunikationseinheit ein SmartMeter-Gateway, wie es zuvor beschrieben worden ist. Die Einbaubuchse, die über die Frontseite erreichbar ist, stellt dabei vorzugweise eine Verbindung zu einem HAN (Home Area Network) bereit. Auf der ersten Platine ist dabei vorzugweise ein HSM (Hardware Security Module) aufgebaut, das eine gesicherte Kommunikation zwischen verschiedenen Netzwerken bereitstellt. Entsprechend wäre auf der ersten Platine bevorzugter Weise eine weitere Einbaubuchse für ein LMN (Local Metrological Network) angeordnet, wobei diese weitere Schnittstelle hinter der Berührungsschutzabdeckung angeordnet ist. Zusätzlich kann eine noch weitere Einbaubuchse vorgesehen sein, die eine Schnittstelle für ein WAN (Wide Area Network) zur Verfügung stellt. Diese noch weitere Einbaubuchse kann beispielsweise mit einem Powerline-Modem verbunden sein, wobei die noch weitere Einbaubuchse wahlweise vor oder hinter der Berührungsschutzabdeckung angeordnet sein kann. Prinzipiell können verschiedenste Gehäuseformen zur Montage auf einer Tragschiene im Zusammenhang mit der erfindungsgemäßen Kommunikationseinheit verwendet werden. Bevorzugter Weise ist das Gehäuse jedoch ein Hutschienengehäuse, das vorzugsweise nach DIN 43880 genormt ist. Das Gehäuse weist dabei vorzugsweise eine Baugröße 1 auf und ist vorzugsweise 5 PLE (Platzeinheiten, auch als Teilungseinheit (TE) bezeichnet) breit.

Es gibt nun verschiedene Möglichkeiten, die Lehre der vorliegenden Erfindung in vorteilhafter Weise auszugestalten und weiterzubilden. Dazu ist einerseits auf die dem Anspruch 1 nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: eine schematische Darstellung eines Hutschienengehäuses in Seitenansicht zur Erläuterung einer Einbausituation,
- Fig. 2: eine Draufsicht auf eine erfindungsgemäße Kommunikationseinheit auf die Frontseite,
- Fig. 3: eine Schrägansicht eines Standard-RJ45-Steckers mit Knickschutzhülle,
- Fig. 4: eine Seitenansicht eines Standard-RJ45-Steckers mit Kabelstück zur Verdeutlichung des minimalen Biegeradius,
- Fig. 5: eine Seitenansicht einer erfindungsgemäßen Kommunikationseinheit mit eingestecktem Standard-RJ45-Stecker und
- Fig. 6: eine teilweise Schnittzeichnung durch die Kommunikationseinheit nach Fig. 5 entlang der Zeichenebene der Fig. 5.

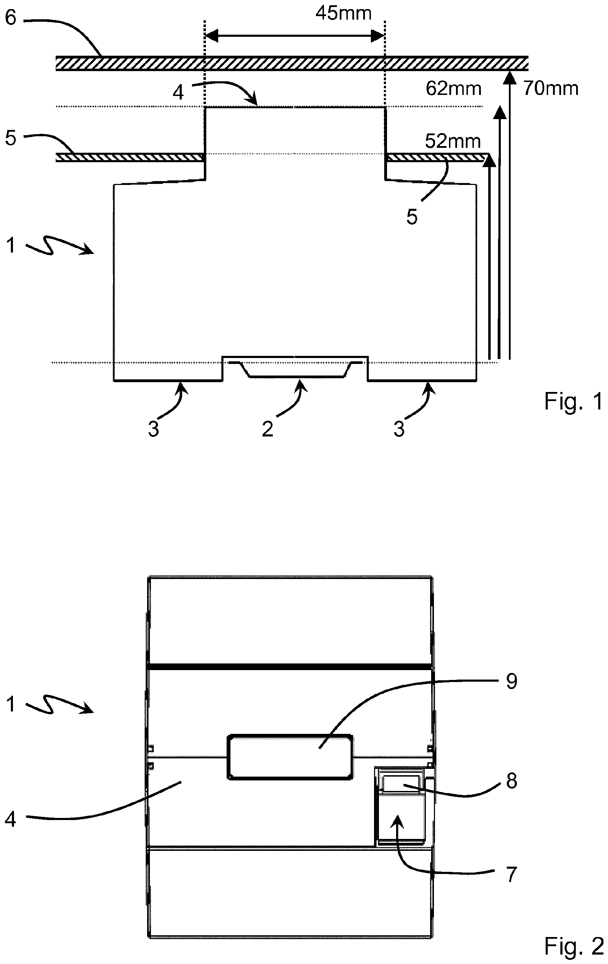

Anhand von Fig. 1 soll zunächst eine dem bevorzugten Ausführungsbeispiel zugrundeliegende Einbausituation näher betrachtet werden. Fig. 1 zeigt eine schematische Darstellung eines Hutschienengehäuses in einer Seitenansicht sowie die gemäß DIN 43880 vorgegebenen Einbaumaße für Baugröße 1 bis 3. Das Hutschienengehäuse 1 ist auf einer Hutschiene 2 montiert. Die der Hutschiene 2 zugewandte Seite des Hutschienengehäuses 1 wird nachfolgend als Montageseite 3 bezeichnet. Die der Montageseite 3 gegenüberliegende Seite wird nachfolgend als Frontseite 4 bezeichnet. Die Frontseite 4 reicht durch eine Berührungsschutzabdeckung 5, die den Bereich hinter der Berührungsschutzabdeckung, d.h. auf der Seite der Hutschiene, gegenüber Berührung und Manipulation schützt. Entsprechend ist die Berührungsschutzabdeckung in der Regel verplombt. Gemäß DIN 43880 ist die Oberfläche der Berührungsschutzabdeckung 52 mm von der Hutschiene 2 entfernt. Das Hutschienengehäuse 1 selbst darf maximal 10 mm über die Berührungsschutzabdeckung 5 hinausragen. Entsprechend ist die Frontseite 4 maximal 62 mm von der Oberkante der Hutschiene 2 entfernt. Vor der Berührungsschutzabdeckung 5 und vor der Frontseite 4 ist eine Türe 6 angeordnet, die den Verteiler, in dem die Hutschiene 2, das Hutschienengehäuse 1 und die Berührungsschutzabdeckung 5 angeordnet sind, abschließt. Die Türe 6 hat dabei einen Abstand von 70mm von der Hutschiene 2. Die Frontseite hat eine Breite von ca. 45 mm.

Fig. 2 zeigt eine Draufsicht auf eine erfindungsgemäße Kommunikationseinheit in einem Hutschienengehäuse 1 mit Blick auf die Frontseite 4. In der Frontseite 4 ist eine Öffnung 7 zu erkennen, die eine ebenso zu erkennende Einbaubuchse 8 freigibt. Durch die Öffnung 7 kann dann ein Stecker in die Einbaubuchse 8 eingesteckt werden. Es ist ferner auf der Frontseite 4 ein Siegel 9 zu erkennen, das eine Manipulation des Gehäuses erkennbar macht. Das in Fig. 2 dargestellte Hutschienengehäuse 1 ist genauer in der deutschen Patentanmeldung 10 2014 220 169 der Anmelderin beschrieben.

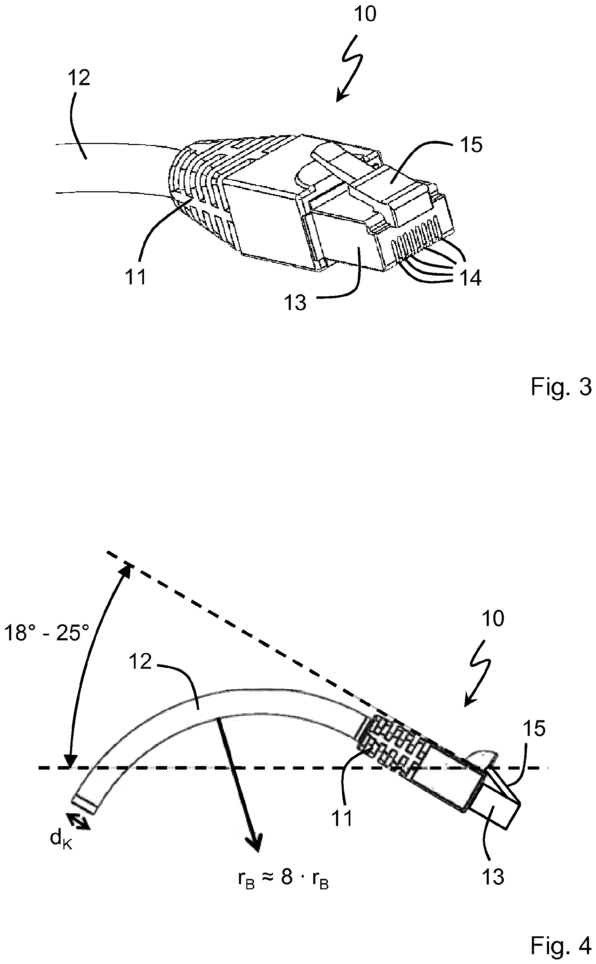

Fig. 3 zeigt eine Seitenansicht eines Standard-RJ45-Steckers 10 mit einer Knickschutzhülle 11, die an den Stecker angespritzt ist. An dem Stecker 10 ist ein Kabel 12 angeschlossen. Der Stecker 10 selbst besteht aus einem im Wesentlichen quaderförmigen Einsteckbereich 13, an dem acht Kontakte 14 ausgebildet sind. An der den Kontakten 14 gegenüberliegenden Seite des Einsteckbereichs 13 ist eine Rastnase 15 ausgebildet, die in eine korrespondierende Vertiefung innerhalb der Einstecköffnung der Buchse eingreift und ein Herausrutschen des Steckers aus der Buchse verhindern soll.

In Fig. 4 ist eine Seitenansicht des Standard-RJ45-Steckers 10 nach Fig. 3 dargestellt. Der Biegeradius r_{B} beträgt bei diesem Kabel 12 achtmal den Durchmesser d_{K} des Kabels. Ferner ist in Fig. 4 der Winkel zwischen der Achse, der Einstecköffnung und der Montageseite des Gehäuses angedeutet, der gemäß einer ganz besonders bevorzugten Weiterbildung im Bereich zwischen 18° und 25° liegt.

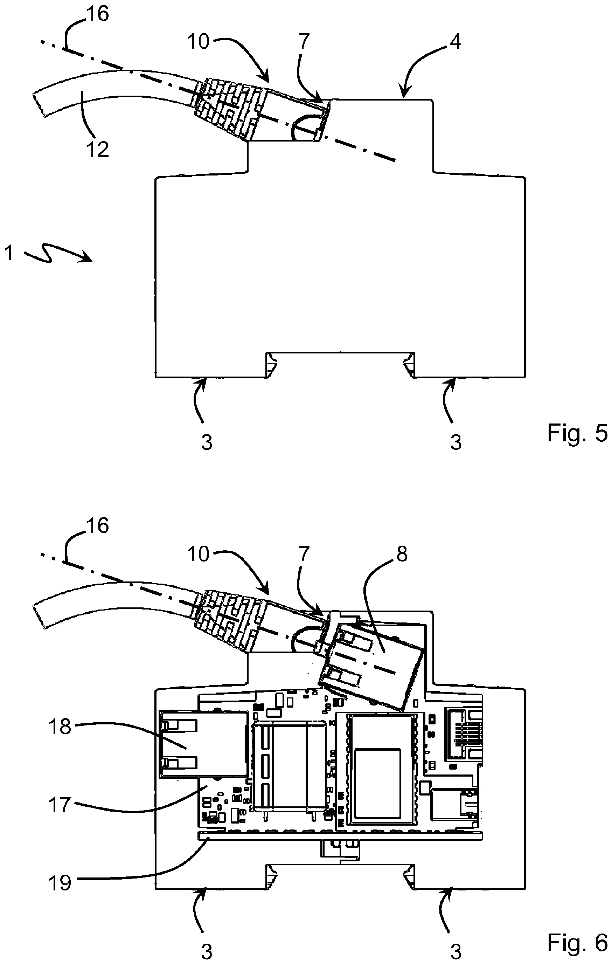

Die Fig. 5 und 6 zeigen ein Ausführungsbeispiel, bei dem eine Achse 16 der Einstecköffnung der Einbaubuchse 8 einen Winkel von ca. 19° zu der Montageseite 3 einschließt. In Fig. 5 ist eine Seitenansicht einer erfindungsgemäßen Kommunikationseinheit in einem Hutschienengehäuse 1 zu erkennen. In eine Öffnung 7 in der Frontseite 4 ist ein Stecker 10 eingesteckt, der durch Ausgestaltung einer Einstecköffnung in einer nicht dargestellten Einbaubuchse entlang der Achse 16 der Einstecköffnung liegt. In Fig. 6 ist eine teilweise Schnittansicht durch die Kommunikationseinheit der Fig. 5 zu erkennen. Stecker 10 ist in die Einststecköffnung der Einbaubuchse 8 eingesteckt. Die Einbaubuchse 8 selbst ist auf einer Platine der Kommunikationseinheit - erste Platine 17 - angeordnet. Es ist zu erkennen, dass die Einbaubuchse 8 an dem der Montageseite 3 abgewandten Randbereich der ersten Platine 17 angeordnet ist und geringfügig über die erste Platine 17 hinausgeht. Die Ecke der Einbaubuchse 8, die am weitesten über die erste Platine 17 hinausgeht und damit am weitesten von der Montageseite 3 entfernt ist, ist in der Öffnung 7 angeordnet und befindet sich annähernd bei der Oberfläche der Frontseite. Die Ecke ist ca. 1 mm unterhalb der Oberfläche angeordnet.

Auf der ersten Platine 17 sind neben der Einbaubuchse 8 einige elektronische Bauteile, wie IC (Integrated Circuits), Transistoren, Widerstände und Kondensatoren, sowie eine weitere Einbaubuchse 18 zu erkennen. Die erste Platine 17 ist mit einer weiteren Platine 19 verbunden, die parallel zu der Montageseite 3 angeordnet ist und beispielsweise zum Verbinden mehrerer weiterer Platinen parallel zu der ersten Platine ausgebildet ist.

Hinsichtlich weiterer vorteilhafter Ausgestaltungen der erfindungsgemäßen Kommunikationseinheit wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele der erfindungsgemäßen Kommunikationseinheit lediglich zur Erörterung der beanspruchten Lehre dienen, diese jedoch nicht auf die Ausführungsbeispiele einschränken.

### Bezugszeichenliste

- 1: Hutschienengehäuse
- 2: Hutschiene
- 3: Montageseite
- 4: Frontseite
- 5: Berührungsschutzabdeckung
- 6: Türe
- 7: Öffnung (für Einbaubuchse)
- 8: Einbaubuchse
- 9: Siegel
- 10: (RJ45) Stecker
- 11: Knickschutzhülle
- 12: Kabel
- 13: Einsteckbereich
- 14: Kontakte (an Stecker)
- 15: Rastnase
- 16: Achse
- 17: (erste) Platine
- 18: weitere Einbaubuchse
- 19: weitere Platine

## Patentansprüche

1. Kommunikationseinheit mit einem Gehäuse zur Montage auf einer Tragschiene und mit mindestens einer in dem Gehäuse angeordneten Platine, wobei das Gehäuse eine der Tragschiene zugewandte Seite - Montageseite (3) - und eine Frontseite (4) aufweist, wobei auf einer der mindestens einen Platine - erste Platine (17) - eine Einbaubuchse (8) angeordnet ist, wobei die Einbaubuchse (8) eine Einstecköffnung (23) aufweist, in die durch eine Öffnung (7) im Gehäuse ein korrespondierender Stecker (10) einsteckbar ist, wobei die Öffnung (7) im Gehäuse zumindest teilweise in der Frontseite (4) gebildet ist und wobei durch die Einstecköffnung (23) eine Achse (16) definiert ist, entlang der ein eingesteckter Stecker (10) angeordnet ist,
**dadurch gekennzeichnet, dass** die erste Platine (17) senkrecht zur Montageseite (3) angeordnet ist und dass die Einbaubuchse (8) derart auf der ersten Platine (17) angeordnet ist, dass die Achse (16) der Einstecköffnung (23) relativ zu der Montageseite (3) einen Winkel zwischen 15° und 30° einschließt.

2. Kommunikationseinheit nach Anspruch 1, **dadurch gekennzeichnet, dass** die Achse (16) der Einstecköffnung (23) relativ zu der Montageseite (3) einen Winkel zwischen 18° und 25°, ganz besonders bevorzugter Weise einen Winkel zwischen 18° und 20° einschließt.

3. Kommunikationseinheit nach Anspruch 1 oder 2, **dadurch gekennzeichnet, dass** die Achse (16) der Einstecköffnung (23) im Wesentlichen parallel zu der ersten Platine (17) ausgerichtet ist.

4. Kommunikationseinheit nach Anspruch 1 oder 2, **dadurch gekennzeichnet, dass** die Achse (16) der Einstecköffnung (23) relativ zu der ersten Platine (17) einen Winkel zwischen 9° und 50°, besonders bevorzugter Weise einen Winkel von 19° ± 3° oder 45° ± 3° einschließt.

5. Kommunikationseinheit nach einem der Ansprüche 1 bis 4, **dadurch gekennzeichnet, dass** die Montageseite (3) im Wesentlichen parallel zu der Frontseite (4) angeordnet ist.

6. Kommunikationseinheit nach einem der Ansprüche 1 bis 7, **dadurch gekennzeichnet, dass** die Einbaubuchse (8) als RJ-Buchse - Registered Jack Buchse, vorzugsweise als RJ45-Buchse ausgebildet ist.

7. Kommunikationseinheit nach einem der Ansprüche 1 bis 8, **dadurch gekennzeichnet, dass** auf der ersten Platine (17) oder gegebenenfalls auf einer anderen in dem Gehäuse angeordneten Platine (19) eine weitere Einbaubuchse (18) angeordnet ist, wobei die Kommunikationseinheit derart ausgebildet ist, dass ein über die Einbaubuchse (8) verbundenes Endgerät mit einem anderen über die weitere Einbaubuchse (18) verbundenen Endgerät kommunizieren kann.

8. Kommunikationseinheit nach einem der Ansprüche 1 bis 9, **dadurch gekennzeichnet, dass** die Kommunikationseinheit ein SmartMeter-Gateway ist und dass die Einbaubuchse (8) eine Verbindung zu einem HAN - Home Area Network - bereitstellt, wobei auf der ersten Platine (17) vorzugsweise ein HSM - Hardware Security Module - aufgebaut ist.

9. Kommunikationseinheit nach einem der Ansprüche 1 bis 10, **dadurch gekennzeichnet, dass** das Gehäuse ein Hutschienengehäuse (1) ist, das vorzugsweise nach DIN 43880 genormt ist, wobei das Gehäuse vorzugsweise eine Baugröße 1 und vorzugsweise eine Breite von 4 PLE - Platzeinheiten - aufweist.

## Claims

1. Communication unit having a housing for assembly on a carrier rail and having at least one circuit board which is arranged in the housing, wherein the housing has a side facing the carrier rail - assembly side (3) - and a front side (4), wherein a built-in socket (8) is arranged on one of the at least one circuit boards - first circuit board (17) - , wherein the built-in socket (8) has an insertion opening (23) in which a corresponding connector (10) can be inserted through an opening (7) in the housing, wherein the opening (7) in the housing is formed at least partially in the front side (4) and wherein there is defined through the insertion opening (23) an axis (16), along which an inserted connector (10) is arranged,
**characterised in that** the first circuit board (17) is arranged perpendicularly to the assembly side (3) and **in that** the built-in socket (8) is arranged on the first circuit board (17) in such a manner that the axis (16) of the insertion opening (23) defines an angle between 15° and 30° relative to the assembly side (3).

2. Communication unit according to claim 1, **characterised in that** the axis (16) of the insertion opening (23) relative to the assembly side (3) defines an angle between 18° and 25°,
in a quite particularly preferred manner an angle between 18° and 20°.

3. Communication unit according to claim 1 or 2, **characterised in that** the axis (16) of the insertion opening (23) is orientated substantially parallel with the first circuit board (17).

4. Communication unit according to claim 1 or 2, **characterised in that** the axis (16) of the insertion opening (23) relative to the first circuit board (17) defines an angle between 9° and 50°, in a particularly preferred manner an angle of 19° ± 3° or 45° ± 3°.

5. Communication unit according to any one of claims 1 to 4, **characterised in that** the assembly side (3) is arranged substantially parallel with the front side (4).

6. Communication unit according to any one of claims 1 to 7, **characterised in that** the built-in socket (8) is constructed as an RJ socket - Registered Jack socket, preferably as an RJ45 socket.

7. Communication unit according to any one of claims 1 to 8, **characterised in that** another built-in socket (18) is arranged on the first circuit board (17) or where applicable on another circuit board (19) which is arranged in the housing, wherein the communication unit is constructed in such a manner that an end device which is connected via the built-in socket (8) can communicate with another end device which is connected via the additional built-in socket (18).

8. Communication unit according to any one of claims 1 to 9, **characterised in that** the communication unit is a Smart Meter Gateway and **in that** the built-in socket (8) provides a connection to a HAN - Home Area Network - , wherein an HSM - Hardware Security Module - is preferably constructed on the first circuit board (17).

9. Communication unit according to any one of claims 1 to 10, **characterised in that** the housing is a top-hat rail housing (1), which is preferably standardised in accordance with DIN 43880, wherein the housing preferably has a structural size 1 and preferably a width of 4 SU - space units.

## Revendications

1. Unité de communication avec un boîtier destiné à être montée sur un rail porteur et avec au moins une platine disposée dans le boîtier, le boîtier comprenant un côté orienté vers le rail porteur, le côté de montage (3) et un côté frontal (4), une prise encastrée (8) étant disposées sur une de l'au moins une platine, la première platine (17), la prise encastrée (8) comprenant une ouverture d'insertion (23) dans laquelle un connecteur (10) correspondant peut être inséré à travers une ouverture (7) dans le boîtier, l'ouverture (7) étant réalisée dans le boîtier, au moins partiellement sur le côté frontal (4), et un axe (16) étant défini à travers l'ouverture d'insertion (23), le long duquel un connecteur (10) inséré est disposée,
**caractérisé en ce que** la première platine (17) est disposée perpendiculairement par rapport au côté de montage (3) et **en ce que** la prise encastrée (8) est disposée sur la première platine (17) de façon à ce que l'axe (16) de l'ouverture d'insertion (23) forme, par rapport au côté de montage (3) un angle entre 15° et 30°.

2. Unité de communication selon la revendication 1, **caractérisée en ce que** l'axe (16) de l'ouverture d'insertion (23) forme, par rapport au côté de montage (3) un angle entre 18° et 25°, de préférence un angle entre 18° et 20°.

3. Unité de communication selon la revendication 1 ou 2, **caractérisée en ce que** l'axe (16) de l'ouverture d'insertion (23) est orientée globalement parallèlement par rapport à la première platine (17).

4. Unité de communication selon la revendication 1 ou 2, **caractérisée en ce que** l'axe (16) de l'ouverture d'insertion (23) forme, par rapport à la première platine (17), un angle entre 9° et 50°, de préférence un angle de 19°±3° ou de 45°±3°.

5. Unité de communication selon l'une des revendications 1 à 4, **caractérisée en ce que** le côté de montage (3) est disposé globalement parallèlement au côté frontal (4).

6. Unité de communication selon l'une des revendications 1 à 7, **caractérisée en ce que** la prise encastrée (8) est conçue sous la forme d'une prise RJ, Registered Jack, de préférence sous la forme d'une prise RJ45.

7. Unité de communication selon l'une des revendications 1 à 8, **caractérisée en ce que**, sur la première platine (17) ou, le cas échéant, sur une autre platine (19) disposée dans le boîtier, se trouve une prise encastrée supplémentaire (18), l'unité de communication étant conçue de façon à ce qu'un terminal relié par l'intermédiaire de la prise encastrée (8) puisse communiquer avec un autre terminal relié par l'intermédiaire de la prise encastrée supplémentaire (18).

8. Unité de communication selon l'une des revendications 1 à 9, **caractérisée en ce que** l'unité de communication est une SamrtMeter-Gateway et **en ce que** la prise encastrée (8) établit une liaison avec un HAN, Home Area Network, de préférence un HSM, Hardware Security Module étant disposé sur la première platine (17).

9. Unité de communication selon l'une des revendications 1 à 10, **caractérisée en ce que** le boîtier est un boîtier sur rail DIN (1), qui est normalisé de préférence selon la norme DIN 43880, le boîtier présentant de préférence une taille 1 et de préférence une largeur de 4 PLE, unités d'encombrement.
